# EUROPEAN PATENT APPLICATION

(11) **EP 2 194 571 A1**
(43) Date of publication of application: **09.06.2010**
(21) Application number: 08171013.9
(22) Date of filing: 08.12.2008
(51) Int. Cl.: H01L 21/56

(54) **Preparation of moulded body with electric circuit**

(71) Applicant: TNO Nederlandse Organisatie voor Toegepast Wetenschappelijk Onderzoek, Schoenmakerstraat 97 2628 VK Delft (NL)
(72) Inventor: Kunen, Joseph Mathias Gerardus, 3123 PN Schiedam (NL); De Zwart, Renatus Marius, 5655 JP Eindhoven (NL); Tacken, Roland Anthony, 5663 SH Geldrop (NL)
(74) Representative: Hatzmann, Martin

(57) **Abstract**

The invention is directed to a method for preparing a moulded body comprising an integrated electric circuit, to a body comprising an integrated electric circuit, and to a device comprising the body.

The method of the invention comprises
- placing one or more electrical components in a mould and fixing the one or more electrical components;
- at least partially moulding said body using a moulding material;
- providing a conductive pattern onto said at least partially moulded body;
- providing one or more conductive interconnections onto said at least partially moulded body; and
- optionally further moulding said body,

wherein the at least partially moulding of said body, the provision of the conductive pattern, and the provision of the one or more conductive interconnections are carried out within said mould.

## Description

The invention is directed to a method for preparing a body comprising an integrated electric circuit, to a body comprising an integrated electric circuit, and to a device comprising said body.

Continually increasing functionality of integrated electrical circuits imposes increasing demands on the manufacturing technologies. The reliability of the most advanced electronics is becoming one of the most important factors in limiting electrical performance. The reliability of electronics is especially important in portable products, because these high performance products with ever higher packaging densities experience, in addition to their operational stress, various environments. When producing ever higher density and higher performance electronic devices, more fundamental limitations are also being encountered. The solutions to these limitations will alter the presently used manufacturing techniques.

In order to protect electrical circuits from harmful effects of the environment (such as moisture and contaminations) the circuit can be encapsulated in an insulating material.

Conventionally, integrated circuits are fabricated using printed circuit board technology. This typically involves the interconnection of active and passive components using techniques such as semi-additive (*e*.*g*. sputtering followed by electroplating and etching; or sputtering followed by electroplating and laser ablation) and fully additive (*e*.*g*. photolithography followed by sputtering and electroplating; or photolithography followed by electroplating) interconnecting, (lead-free) soldering, reflow soldering, wire bonding, and conductive gluing. However, these interconnection methods make the design of the device complex, considerably limit the product possibilities and shapes, and increase the number of manufacturing steps.

Accordingly, there have been a number of attempts to improve the conventional printed circuit board technology for miniaturisation and function-integration purposes. Such attempts for instance involve placing electrical components on top of each other and making conductive tracks using metallising techniques.

WO-A-00/67538, for instance, describes a printed circuit board manufacturing process in which the embedded microcircuits and electrical components are processed and interconnected solderlessly into electrically functional devices or modules.

Nevertheless, the printed circuit board technique has a drawback in that the form of the final electrical circuit is always imposed by the initial flat board. It would be desirable to have a fabrication technique for integrated electrical circuits that provides a much higher degree of freedom with respect to the form of the product that comprises the electrical circuit. This would allow much more flexibility in the design and manufacturing of electronic devices.

An alternative for the printed circuit board technology is the moulded interconnect device technology. This technology, aiming at the combination of electrical and mechanical functions in a single body, is a chain production technology. The moulded interconnect device technology comprises the injection moulding of a polymeric metallisable substrate, the metallisation of a conductive circuit on the substrate, and the assembly of surface mount device components. Galvanic and electroless bath plating are used in metallisation of the circuit. In the assembly step, the interconnections between the components and the conductive circuit are made with techniques such as (lead-free) soldering, reflow soldering, thin film technology, thick film technology, ultrasonic wire bonding, and conductive gluing.

As the printed board circuit technology, the moulded interconnect device technology has the drawback that the interconnection methods hinder the functional and free form design possibilities, as the resulting body is essential two-dimensional in shape. An additional disadvantage of the technology is the involvement in the manufacturing process of several manufacturers, negatively influencing yield and production time.

Object of the invention is to provide a novel fashion of preparing a body with an integrated electric circuit.

Another object of the invention is to provide a method for manufacturing a body with an integrated electrical circuit that allows a substantial degree of freedom with respect to the form of the body.

Further object of the invention is to provide a method for manufacturing a body having an integrated electrical circuit that is well protected against harmful influences from the environment.

Yet another object of the invention is to provide a method for manufacturing a body with an integrated electric circuit using a small amount of fabrication and calibration steps.

Yet a further object of the invention is to provide a method which incorporates the manufacturing of a body with integrated electric circuit into the manufacturing process of a device.

It was found that one or more of these objects can be met by manufacturing a body with an integrated electric circuit using an in-mould fabrication technique.

Accordingly, in one aspect the invention is directed to a method for preparing a body comprising an integrated electric circuit, said method comprising
- placing one or more electrical components in a mould and fixing the one or more electrical components;
- at least partially moulding said body using a moulding material;
- providing a conductive pattern onto said at least partially moulded body;
- providing one or more conductive interconnections onto said at least partially moulded body; and
- optionally further moulding said body,
wherein the at least partially moulding of said body, the provision of the conductive pattern, and the provision of the one or more conductive interconnections are carried out within said mould.

The invention allows the manufacture of mouldable products with integrated electronics entirely within the mould. Not only can conductive tracks be provided in the mouldable product, but also active and/or passive electrical components can be provided in the product, interconnections between bare and/or encapsulated components can be made, and contact points to the outside can be realised. As a consequence of having less production and intermediate calibration steps the process will take shorter than conventional printed circuit board technology and moulded interconnect device technology, and accordingly the costs will be lower. Furthermore, the invention allows the production of high-quality and well-integrated devices. Moreover, this entirely new approach does not have the usually faced limitations with respect to function integration and miniaturisation, and therefore opens a new window of opportunities.

One step in the method of the invention is the placing of one or more electrical components in a mould and fixing the one or more electrical components. The components can be fixed on the inside wall of the mould, for instance by providing the inside wall of the mould with suitable recesses in which the components fit. Other possibilities of fixing the components to the mould include gluing (adhesives, adhesive tape) and mechanical clamping. It is also possible to fix the components to a body that has previously been at least partially moulded, *e*.*g*. by gluing and other methods such as described in US-A-2008/0 222 876. Fixing the components ensures that the components are positioned in pre-determined locations of the body and are not able to move away from these locations.

In another step of the method of the invention, the body is at least partially moulded. This step may be carried out before or after placing and fixing the electrical components into the mould.

Suitable moulding techniques that can be used for the invention include casting, injection moulding, co-injection moulding, multi-material moulding, gas injection moulding, water injection moulding, injection transfer moulding, injection compression moulding, core-pull injection moulding, and turn-table moulding, and combinations thereof.

The body is preferably prepared from a metallisable moulding material. Such moulding materials can for instance comprise a thermoplastic material, a thermosetting material, and/or a ceramic material. Suitable examples of thermoplast materials include liquid crystalline polymer, polyamide 6, polyamide 6/6, polyamide 4/6, polyamide 12, poly(phenylene sulphide), polyetherimide, polybutylene terephthalate, syndiotactic polystyrene, polyethylene terephthalate, polycarbonate, polyetheretherketone, polyimide, polyethylene naphthalate, polytetrafluorethylene, acrylonitrile-butadiene-styrene, polycarbonate/acrylonitrile-butadiene-styrene, polypropylene, and polyethylene. Suitable examples of thermoset materials include epoxy compounds, melamine, bakelite, and polyester compounds. Suitable ceramic materials include alumina, zirconia, silica and glass. Preferably, the moulding material is a thermoplastic material comprising liquid crystal polymer, polyamide, polyetherimide, polyethylene terephthalate, acrylonitrile-butadiene-styrene, and/or polycarbonate/acrylonitrile-butadiene-styrene.

In order to avoid expansion problems that might occur during moulding and future use of the resulting product, the moulding material can comprise additives to adapt the expansion of the moulding material to that of the material of the conductive pattern and/or of the materials of the electrical components. If this insufficiently compensates the differences in expansion, it is possible to use a highly filled elastic underfill material, as is well-known from printed circuit board technology. Such material is applied around and/or under the components and can overcome part of the difference in expansion during fabrication and subsequent usage.

The above-mentioned placing of the electrical components and at least partially moulding the body result in a substrate, which can be used for the subsequent provision of a pattern of conductive tracks for the electrical circuit, and the provision of one or more interconnections for the electrical components, including the provision of electrical contacts that allow communication with the outside.

Method of the invention provides a number of different possibilities to provide the conductive pattern and the one or more conductive interconnections inside an injecting moulding mould. Depending on the situation and specific needs for the end-product, the skilled person will be able to determine the most suitable production method for a specific case.

In an advantageous embodiment of the invention, the conductive pattern and the one or more conductive interconnections are provided simultaneously, preferably in the same step. Furthermore, it is preferred that the conductive pattern is a metallic pattern and/or that the one or more conductive interconnections are metallic interconnections. Such a metallic pattern and metallic interconnections can for instance be prepared using an electroless plating process. Accordingly, in an embodiment the provision of the conductive pattern and/or the one or more conductive interconnections comprises in-mould electroless plating. In electroless plating use is made of the principle that a metal which is available in ionic form in solution can be reduced by a reducing agent into its metallic form on a suitable surface. Moreover, the metal itself should also be catalytic to the reduction reaction, rendering the process as such autocatalytic. For a general description on electroless plating processes reference can, for instance, be made to Electroless Plating Fundamentals & Applications, edited by Glenn O. Mallory and Juan B. Hajdu, New York, 1990.

The electroless plating can involve the use of an electroless plating solution that comprises metal ions and a reducing agent for reducing the metal ions into the corresponding metal, thereby enabling the metal to be deposited onto the at least partially moulded body.

The metal can for instance be selected from the group consisting of copper, nickel, tin, silver, gold, or any alloy thereof. Also suitable alloys such as nickel phosphorous and nickel boron can be used.

Examples of reducing agents include formaldehyde, hypophosphite, dimethylaminoborane, sodium borohydride, and hydrazine.

The plating solution can further comprise a complexing agent, such as acetate, propionate, succinate, hydroxyacetate, ammonia, hydroxypropionate, glycolic acid, aminoacetate, ethylenediamine, aminopropionate, malonate, pyrophosphate, malate, citrate, gluconate, tartate, ethylenediaminetetraacetic acid (EDTA), propionitrile, tetraethylenetetraamine, 1,5,8,12-tetraazaundodecane, 1,4,8,12-tetraazacyclopentadecane, and 1,4,8,11-tetraazaundecane.

A buffering agent can also be included in the plating solution. Suitable buffering agents include acetic acid, propionic acid, succinic acid, glutaric acid, adipic acid, organic amines, and carboxylic acids.

In addition, the plating solution may comprise stabiliser, such as heavy metal ions, an organic or inorganic sulphur-containing compound, an organic or inorganic selenium-containing compound, or an organic or inorganic tellur-containing compound.

Electroless plating may comprise a catalyst seeding step. The catalyst material can than for instance be incorporated in the moulding material or additionally applied via a fluid into the mould prior to the electroless plating solution. This can be done in the same fluid circuitry that is used for the plating solution.

To obtain good adhesion between moulded material and metal, it may be advantageous in some cases to execute a wet etching step prior to (facultative) catalyst application and subsequent electroless metallisation. By etching the at least partially moulded body, *e*.*g*. a plastic, can be activated and/or roughened to obtain a densely catalyst surface and/or a well adherent metallic pattern. The etching fluid may be applied through the same tubing as the metallisation fluids. A wet etching step can also be used to expose a catalyst when using a moulding material comprising a catalyst material.

Suitably, the conductive pattern and/or the one or more conductive interconnections are provided by exposing the at least partially moulded body to an electroless plating solution, whereby at least the surface of the at least partially moulded body has a temperature or is heated to a temperature (T1) which is higher than the temperature (T2) of the electroless plating solution. In this respect, reference can be made to the non-prepublished European patent application number 07115731.7. This has the advantages that no catalyst needs to be incorporated in the moulding material or applied on the substrate surface to initiate and catalyse the metallisation process. Moreover, metal deposition is rapid because of the high temperatures applied. Suitably, temperature T1 is in the range of 50-200 °C, preferably in the range of 80-180 °C, more preferably in the range of 70-140 °C. Suitably, temperature T2 is in the range of 15-90 °C, preferably in the range of 15-60 °C, more preferably in the range of 15-25 °C. Thus, T2 can suitably be the ambient temperature.

In an embodiment of the present invention use is made of metal paste, *i*.*e*. a paste comprising metal particles and a binder material, or a conductive paint or ink.

In one embodiment, the provision of the conductive pattern and/or the provision of said one or more conductive interconnections comprises
- providing the at least partially moulded body with a pattern of a catalyst for electroless plating of the conductive tracks and/or with a pattern of catalyst for electroless plating of one or more interconnections; and
- metallising said pattern and/or interconnections by electroless plating.
   Suitable catalyst materials for electroless plating can for instance be selected from the group consisting of cobalt, nickel, copper, rhodium, palladium, platinum, silver, and gold. Palladium is a particularly preferred catalyst material.
   The pattern of catalyst for the conductive tracks and/or the pattern of catalyst for the one or more interconnections can be applied onto the at least partially moulded body by means of a stamp with a desired pattern provided with said catalyst for electroless plating. Hence, the patterned stamp is provided with the catalyst material, and subsequently the stamp is brought into contact with the at least partially moulded body, thereby transferring the pattern or patterns of catalyst material onto the at least partially moulded body. Thereafter, the pattern or patterns of catalyst material can be used as seed for an electroless plating process during which the pattern for the conductive tracks and/or the pattern for the interconnections is/are metallised.
   It is also possible to first press a reverse image of the pattern for the conductive tracks and/or for interconnections into the at least partially moulded body using a stamp with the desired pattern and thereby provide the at least partially moulded body with a structured surface (a surface having recesses and protrusions). Thereafter, a smooth stamp provided with the catalyst material is used to apply the pattern of the conductive tracks and/or of the interconnections onto the structured surface of said at least partially moulded body. By first creating a structured surface the catalyst material will less likely run out into the non-desired areas, as opposed to an unstructured surface (a surface without recesses or protrusions). Thereafter, the pattern of catalyst material can be used as seed for an electroless plating process during which the tracks and/or interconnections are metallised.
   Another option is to press a stamp with the desired pattern into the at least partially moulded body and thereby provide the at least partially moulded body with a structured surface (a surface having recesses and protrusions). The patterned stamp can then be provided with the catalyst material, after which the patterned stamp is used to apply the catalyst onto the structured surface of the at least partially moulded body, and the catalyst material is used as seed for an electroless plating process during which the tracks and/or interconnections are metallised.
   In another embodiment, the provision of said conductive pattern and/or the provision of said one or more conductive interconnections comprises
- providing said at least partially moulded body with a reverse image of said pattern and/or interconnections of inhibition material; and
- metallising said pattern and/or interconnections by electroless plating.

Suitable inhibition materials can for instance be selected from the group consisting of heavy metal ions, organic and inorganic sulphur-containing compounds, organic and inorganic selenium-containing compounds, organic and inorganic tellur-containing compounds, oxygen-containing compounds, and aliphatic and unsaturated organic compounds. Preferably, the inhibition material comprises dodecanethiol, dipyridil, lead acetate, maleic acid, 2-mercaptobenzothiazole and/or thiourea. Most preferably, the inhibition material comprises 2-mercaptobenzothiazole and/or thiourea.

The reverse image of the tracks and/or interconnections of inhibition material can be applied onto the at least partially moulded body by means of a stamp with the reverse of the desired patterned structure provided with the inhibition material. Hence, the patterned stamp is provided with the inhibition material, and subsequently the stamp is brought into contact with the at least partially moulded body, thereby transferring the pattern of inhibition material onto the at least partially moulded body. Thereafter, at least partially moulded body can be metallised at locations that are free from inhibition material, thereby providing the at least partially moulded body with the desired conductive pattern and/or one or more conductive interconnections.

It is also possible to first press a stamp with the desired pattern into the at least partially moulded body, and thereby provide the at least partially moulded body with a structured surface (a surface having recesses and protrusions). Thereafter, a smooth stamp provided with the inhibition material can be used to apply the reverse image of the pattern and/or interconnections of inhibition material onto the structured surface of said at least partially moulded body. Then, the at least partially moulded body can be metallised at locations that are free from inhibition material, thereby providing the at least partially moulded body with the desired conductive pattern and/or one or more conductive interconnections.

Another option is to first press the reverse image into the at least partially moulded body using a patterned stamp thereby provided the at least partially moulded body with a structured surface (a surface having recesses and protrusions). Then, the patterned stamp can be provided with the inhibition material, after which the patterned stamp is used to apply the inhibition material onto the structured surface of the at least partially moulded body. Thereafter, the at least partially moulded body can be metallised at locations that are free from inhibition material, thereby providing the at least partially moulded body with the desired conductive pattern and/or one or more conductive interconnections.

After metallisation, the inhibitor material may optionally be removed. This can for instance be realised by rinsing with a suitable solvent.

In the cases where use is made of an inhibition material, the catalyst material may be provided as a separate step, for instance using a smooth stamp that is provided with catalyst material. However, it is also possible to use a moulding material that comprises catalyst material and thereby inherently acts as seed material for an electroless plating process. Only at locations where the inhibition material has been deposited, the moulding material does not metallise. Accordingly, when a reverse image of the desired pattern and/or interconnections is provided on the at least partially moulded body, metallisation of the catalyst-containing mouldable material will only take place at the desired locations.

Advantageously, the mould may comprise one or more of the above-mentioned stamps. Thus, for instance, part of the inner mould wall can act as a patterned or smooth stamp in the above-mentioned techniques for providing the at least partially moulded body with a conductive pattern and one or more conductive interconnections.

In a favourable embodiment, the method of the invention is therefore conducted using so-called turn-table moulding. Turn-table moulding allows a multi-step fabrication process, wherein the product to be made can be successively rotated along different processing positions on the turn-table. In between the successive fabrication steps, all moulds on the turn-table are opened simultaneously, so that the intermediate products can be rotated to the next positions. The process is *e*.*g*. described in DE-A-3340122. For example, this allows to place, using *e*.*g*. a robot, and fix components in the mould cavity in the first position on the table, to mould a body in the next one, and to press a pattern into the moulded body, to apply catalyst material where needed, to metallise the patterned moulded body at the locations of the catalyst material and to eject the metallised product in the successive positions on the table. Naturally, any combination of different mould halves can be installed on the turn-table, which provides the skilled person with enormous flexibility of manufacture and possibilities for design. A fabrication process comprising too many successive steps can be divided in two or more sub-processes that are carried out on two or more manufacturing facilities.

In a manufacturing setup the metallisation fluids may be transferred from containers into the mould using pumps to transfer the metallisation fluids through tubing into the mould. In order to protect mould parts from being damaged by metallisation fluids, the mould parts can suitably be provided with a protective coating. In particular, a diamond like carbon coating has been found to be suitable for this purpose. Advantageously, fluid buffers, pumps and tubing are physically integrated in the mould.

Clogging of the electroless plating fluids circuitry (tubings, pumps, cavities) can be prevented by proper design and material selection of the components used. More specifically, it has been found that a periodic cleaning step of the fluidic system, *e*.*g*. by purging with concentrated nitric acid, is suitable to prevent clogging of the fluidic system. When steel moulds are used in combination with copper metallisation, for example, it can be advantageous to purge with concentrated nitric acid, since the copper dissolves fast and the steel passivates in the nitric acid solution.

Channels for the flow of the metallisation fluids inside the mould above the at least partially moulded body can be created by means of core-pull injection moulding or turn-table injection moulding.

Pulling a slide above the at least partially moulded body opens a flow channel inside the mould through which the metallisation fluid(s) (required to make a conductive track and/or conductive interconnections) can be pumped. The aspect ratio of a channel (depth-width ratio) is preferably in the order of 1-10. With a special mould part (a part having a flow channel as recess) such a channel can also be created at one of the positions on a turn-table. This approach has the drawback that the mould and fluid setup becomes very complicated when the desired conductive circuit comprises several tracks, because every track required its own flow channel. Furthermore, pitch and width of such tracks normally have lower limits of about 1 mm and 0.3 mm, respectively.

The application of an inhibition layer on the at least partially moulded body enables the metallisation of the entire conductive circuit, including required interconnections, in one time. Pulling a slide or using a special mould part creating a slit channel above the part of the at least partially moulded body defined by the inhibition layer enables a slit flow of the metallisation fluid(s) over the at least partially moulded body. The aspect ratio of a slit channel can be (much) smaller than 1. The lower limits of pitch and width of the tracks in the electric circuit are typically about 0.001 mm and 0.0005 mm, respectively.

In yet a further embodiment, the at least partial moulding of the body comprises a moulding process in which one or more hollows or channels for the conductive pattern and/or one or more conductive interconnections are made in or through the at least partially moulded body. The preparation of such hollows or channels is *e*.*g*. described in WO-A-2008/063063. This is for instance possible by injecting gas or water in an at least partially moulded body and thereby removing not-yet solidified matter in order to create one or more hollows or channels.

Another possibility is to apply core-pull injection moulding, in which one or more slides having circular or other cross-sections can be pulled out of the least partially moulded body in order to create one or more hollows or channels. The one or more hollows and/or channels so created then provide the design (or at least part of the design) for the conductive pattern and/or one or more conductive interconnections (see *e*.*g*. WO-A-2008/063063). Thus, in order to allow the particular conductive pattern to be deposited, the plating solution comprising the metal ions and reducing agent can be put into contact with the desired parts of the at least partially moulded body by way of the one or more created hollows and/or channels.

Suitably, two or more of the different embodiments and possibilities for providing the at least partially moulded body with the conductive pattern and the one or more conductive interconnections can be combined depending on the specific needs.

At least the steps of at least partially moulding of the body, providing the conductive pattern, and providing the one or more conductive interconnections can be repeated a number of times to create complex devices, such as a repetition of 2-20 times, preferably 2-10 times. The present invention enables the interconnection between circuits and/or components situated in different layers, metallising connecting conductive tracks and/or vias internally.

For some applications it may be desirable to use conventional printing circuit board interconnection techniques in addition to the one or more interconnections provided by the method of the invention. Thus, in addition, electrical components may be interconnected by semi-additive and fully additive interconnecting, (lead-free) soldering, reflow soldering, wire bonding, and/or conductive gluing.

For some applications it may also be desirable to make use of other techniques known in the art to make conductive patterns and/or interconnections, such as moulding with conductive polymers, thin film technology, thick film technology, the incorporation of conductive glues and/or pastes, painting with conductive material, and/or printing with conductive ink.

In a further aspect the invention is directed to a body comprising an integrated electric circuit as obtained according to the method of the invention, while full advantage is taken of the design freedom with respect to the form of the body. A wide variety of moulded bodies comprising a conductive pattern can be prepared. Suitable examples of such products include, but are not limited to, three-dimensional electric circuits, such as interconnection parts, sensors, antenna structures and/or actuators, and articles such as bathroom articles, reflectors, jewellery, reflectors, toys or decorative articles.

In yet a further aspect the invention is directed to a device comprising a body as obtained according to the method of the invention. The manufacturing of such a body is incorporated in the manufacture process of the device, and the body becomes a structurally and/or decoratively integrated part of the device. Suitable examples include but are not limited to devices for use in automotive applications, communication applications (such as mobile phones) computers, consumers electronics (such as digital cameras), health and surveillance systems, safety and monitoring systems, and processing applications.

The invention will now further be illustrated by means of the following Examples.

### Examples

In an injection moulding setup the feasibility of in mould metallisation was demonstrated.

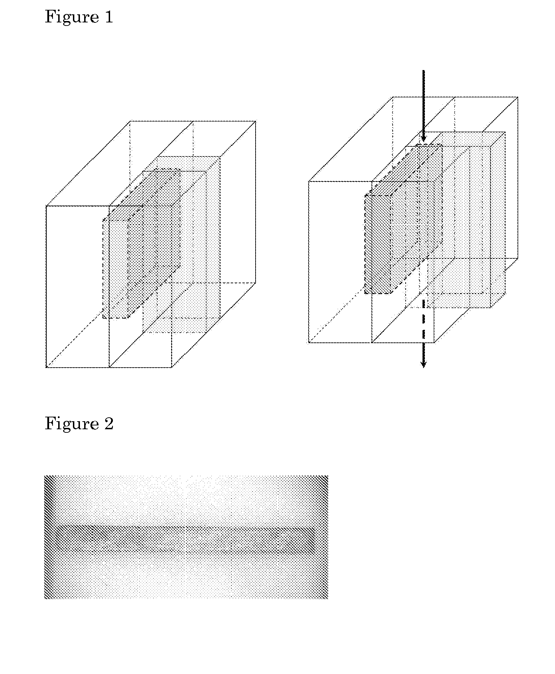

The mould used had a rectangular cavity (dimensions: 20 × 20 × 2 mm³) with an edge injection gate. Figure 1 is a schematic presentation of the mould with square cavity and slide (edge gate not shown); at the left with slide closed, at the right with slide pulled. In the stationary part of the mould a slide is installed which, when pulled, opens a flow channel above the moulded part. The channel runs the entire height of the cavity, having a width of 2 mm. The depth of the channel can be adjusted in the range of 0.2 to 3.0 mm. With small tubing installed at both sides of the channel the in- and outflow of metallisation liquids is enabled. A syringe pump completes the flow system ensuring a steady, slow throughput of the liquids.

In all injection metallisation experiments a non-catalytic, glass fibre reinforced polyamide (PA4/6 GF30) was injected at a melt temperature of 320 °C, and the slide was pulled for 2.0 mm.

Metallisation was conducted in one set of experiments by means of the catalytic metallisation approach. Metallisation comprised a palladium catalyst seeding step with the commercial available CU9040 solution of Cookson Electronics, followed by electroless plating with the copper containing CU9070 solution, also of Cookson Electronics.

A mould temperature of 90 °C resulted in copper deposition on that part of the PA substrate becoming available for metallisation after pulling of the slide. Figure 2 shows a detail of the partly metallised substrate.

In another set of experiments the thermally triggered metallisation route was followed.

In this case, no catalyst seeding was required to yield copper deposition. A copper sulphate (CuSO₄·5H₂O) containing fluid, as described in *Electroless plating of copper at a low pH level* of R. Jagannathan and M. Krishnan, IBM J. Res. Develop., 1993, 37(2): p. 117, was successfully employed for metallisation. However, adjustment of the indicated composition was needed to trigger the copper deposition reaction in the mould having a temperature of 120 °C. The electroless plating solution used had a pH of 9.0, contained CuSO₄·5H₂O in an amount of 0.032 mol/l, was buffered with triethanolamine at a concentration of 0.31 mol/l, stabilised with 1,5,8,12-tetraazaundodecane as complexing agent at 0.035 mol/l, and contained as reducing agent dimethylaminoborane at 0.13 mol/l.

## Claims

1. Method for preparing a body comprising an integrated electric circuit, said method comprising
- placing one or more electrical components in a mould and fixing the one or more electrical components;
- at least partially moulding said body using a moulding material;
- providing a conductive pattern onto said at least partially moulded body;
- providing one or more conductive interconnections onto said at least partially moulded body; and
- optionally further moulding said body,
wherein the at least partially moulding of said body, the provision of the conductive pattern, and the provision of the one or more conductive interconnections are carried out within said mould.

2. Method according to claim 1, wherein the provision of said conductive pattern and the provision of said one or more conductive interconnections are carried out simultaneously.

3. Method according to claim 1 or 2, wherein the provision of said conductive pattern and/or the provision of said one or more conductive interconnections comprises an electroless plating step.

4. Method according to any one of the preceding claims, wherein the provision of said conductive pattern and/or the provision of said one or more conductive interconnections comprises
- providing said at least partially moulded body with a pattern of a catalyst for electroless plating of the conductive tracks and/or with a pattern of a catalyst for electroless plating of one or more interconnections; and
- metallising said pattern and/or interconnections by electroless plating.

5. Method according to claim 4, wherein said pattern of catalyst for the conductive tracks and/or said pattern of catalyst for the one or more interconnections are applied onto the at least partially moulded body by means of a patterned stamp provided with said catalyst for electroless plating.

6. Method according to claim 4, wherein a reverse image of said pattern of conductive tracks and/or said pattern of interconnections is pressed into said at least partially moulded body using a patterned stamp thereby providing said at least partially moulded body with a structured surface, and
wherein thereafter a smooth stamp with said catalyst for electroless plating is used to apply the conductive tracks pattern and/or interconnections pattern onto the structured surface of said at least partially moulded body.

7. Method according to claim 4, wherein a patterned stamp is pressed into said at least partially moulded body thereby providing said at least partially moulded body with a structured surface, the patterned stamp is then provided with said catalyst for electroless plating, and thereafter the patterned stamp is used to apply the catalyst onto the structured surface of the at least partially moulded body.

8. Method according to any one of the preceding claims, wherein the provision of said conductive pattern and/or the provision of said one or more conductive interconnections comprises
- providing said at least partially moulded body with a reverse image of said pattern and/or interconnections of inhibition material; and
- metallising said pattern and/or interconnections by electroless plating.

9. Method according to claim 8, wherein the reverse image of said pattern and/or interconnections of inhibition material is applied onto said at least partially moulded body using a patterned stamp provided with the inhibition material.

10. Method according to claim 8, wherein a patterned stamp is pressed into said at least partially moulded body thereby providing said at least partially moulded body with a structured surface, and wherein thereafter a smooth stamp with the inhibition material is used to apply the reverse image of said pattern and/or interconnections of inhibition material onto the structured surface of said at least partially moulded body.

11. Method according to claim 8, wherein the reverse image is pressed into said at least partially moulded body using a patterned stamp thereby providing said at least partially moulded body with a structured surface, the patterned stamp is then provided with the inhibition material, and thereafter the patterned stamp is used to apply the inhibition material onto the structured surface of the at least partially moulded body.

12. Method according to any one of claims 1-4 and 8-11, wherein said moulding material comprises a catalyst for electroless plating.

13. Method according to any one of claims 5-7 or 9-11, wherein said patterned stamp and/or said smooth stamp are comprised in one or more parts of said mould.

14. Method according to any one of the preceding claims, wherein said at least partially moulding the body comprises a moulding process in which one or more hollows or channels for the conductive pattern and/or one or more conductive interconnections are made in, through and/or adjacent to the at least partially moulded body.

15. Method according to claim 14, wherein said moulding process is a core-pull injection moulding process in which a slide is pulled, thereby creating the one or more hollows or channels adjacent to the at least partially moulded body.

16. Method according to 14, wherein said moulding process is a turn-table injection moulding process in which a mould part is applied, which mould part has one or more hollows or channels as recesses.

17. Method according to any one of claims 14-16, wherein a catalyst for electroless plating is led through said one or more channels before leading an electroless plating solution through said one or more channels.

18. Method according to any one of the preceding claims, wherein the electrical components are placed into the mould and fixed before at least partially moulding the body.

19. Method according to any one of claims 1-17, wherein the electrical components are placed into the mould after at least partially moulding the body and wherein the electrical components are fixed to the mould and/or to the at least partially moulded body.

20. Method according to any one of claims 3-19, wherein said electroless plating comprises using an electroless plating solution that comprises metal ions and a reducing agent for reducing the metal ions into the corresponding metal, enabling the metal to be deposited onto the at least partially moulded body.

21. Method according to any one of the preceding claims, wherein at least the steps of at least partially moulding of the body, providing the conductive pattern, and providing the one or more conductive interconnections are repeated for 2-20 times, preferably 2-10 times.

22. Method according to any one of the preceding claims, wherein the conductive pattern and/or the one or more conductive interconnections are provided by exposing the at least partially moulded body to an electroless plating solution, which solution comprises metal ions and a reducing agent for reducing the metal ions into the corresponding metal, whereby at least the surface of the at least partially moulded body has a temperature or is heated to a temperature (T1) which is higher than the temperature (T2) of the electroless plating solution.

23. Method according to any one of the preceding claims, wherein said moulding is selected from the group consisting of casting, injection moulding, co-injection moulding, multi-material moulding, gas injection moulding, water injection moulding, injection transfer moulding, injection compression moulding, core-pull injection moulding, turn-table moulding, and combinations thereof.

24. Method according to any one of the preceding claims, wherein the moulding material comprises a thermoplastic material, a thermosetting material, and/or a ceramic material.

25. Method according to claim 24, wherein the moulding material comprises one or more materials selected from liquid crystalline polymer, polyamide 6, polyamide 6/6, polyamide 4/6, polyamide 12, poly(phenylene sulphide), polyetherimide, polybutylene terephthalate, syndiotactic polystyrene, polyethylene terephthalate, polycarbonate, polyetheretherketone, polyimide, polyethylene naphthalate, polytetrafluorethylene, acrylonitrile-butadiene-styrene, polycarbonate/acrylonitrile-butadiene-styrene, polypropylene, polyethylene, epoxy compounds, melamine, bakelite, polyester compounds, alumina, zirconia, silica and glass.

26. A body comprising an integrated electric circuit obtained by a method according to any one of the preceding claims.

27. A device comprising a body according to claim 26.
